# FASCICULE DE BREVET EUROPEEN

(11) **EP 1 936 805 B1**
(45) Date de publication et mention de la délivrance du brevet: **01.07.2009**
(21) Numéro de dépôt: 07122705.2
(22) Date de dépôt: 10.12.2007
(51) Int. Cl.: H03H 9/24

(54) **Oscillateur mécanique formé d'un réseau d'oscillateurs élémentaires**
Aus einem Netzwerk von elementaren Oszillatoren gebildeter mechanischer Oszillator.
Mechanical oscillator formed of a network of elementar oscillators

(30) Priorité: 22.12.2006 FR 0655909
(43) Date de publication de la demande: 25.06.2008
(73) Titulaire: COMMISSARIAT A L'ENERGIE ATOMIQUE, 75015 Paris (FR)
(72) Inventeur: Delevoye, Elisabeth, 38000 Grenoble (FR); Barbe, Jean-Charles, 38000 Grenoble (FR)
(74) Mandataire: Poulin, Gérard

(56) Documents cités:
- WO-A-20/06083482
- FR-A1- 2 876 180
- US-A- 5 869 760
- US-A1- 2002 105 393
- US-A1- 2005 206 479

## Description

L'invention concerne un oscillateur mécanique formé d'un réseau d'oscillateurs élémentaires.

Ce réseau d'oscillateurs mécaniques élémentaires présente des couplages aptes à propager un signal ou une perturbation d'une position initiale à d'autres endroits du réseau. Les domaines dans lesquels l'évolution spatiale ou temporelle de signaux et de leur phase est exploitée sont les systèmes non linéaires ou chaotiques, le codage ou le décodage d'informations, les systèmes d'analyse de la propagation de perturbations, les réseaux de neurones, les systèmes d'interprétation de conditions aux limites par génération d'états stationnaires représentatifs, les réseaux permettant l'amplification et l'analyse de grandeurs perturbatrices instationnaires, et les réseaux sensibles à une grandeur physique perturbatrice comme une variation de pression, d'accélération ou autre. Le réseau d'oscillateurs pourra être construit par des techniques de dépôt et de gravure utilisées en micromécanique.

Plusieurs réseaux d'oscillateurs mécaniques couplés entre eux ont été proposés dans les documents de l'état de la technique, quoique les réalisations concrètes semblent avoir été peu nombreuses. Dans le document "Surface micromachine segmented mirrors for adaptive optics" (Cowan W.D.; Lee M.K.; Welsh, B.M. Bright, V.M.; Roggemann, M.C.; IEEE Journal of Selected Topics in Quantum Electronics, Vol 5, Issue 1, Jan.-Feb. 1999 Page(s): 90-101), un couplage entre des poutres vibrantes parallèles est réalisé par une poutre ou un fil de liaison. Un couplage fort ou faible est obtenu entre les poutres vibrantes d'après la rigidité relative de ce dispositif de liaison ; mais il reste immuable alors qu'il serait souhaité de pouvoir le régler dans bien des applications, et on ne voit pas comment étendre un tel couplage à un réseau important, notamment bidimensionnel, de poutres. Dans une conception un peu différente, représentée dans le brevet US 6 917 138 B2, un couplage entre oscillateurs est réalisé par une poutre déformable et élastique qu'on peut modéliser comme un ressort dont les caractéristiques peuvent être ajustées pour définir les modes de résonance de l'ensemble. L'inconvénient du couplage à ressort est que l'échange d'énergie entre les oscillateurs élémentaires est excessif et que les oscillateurs ne peuvent donc en général pas se stabiliser. D'autres conceptions de l'art antérieur possèdent l'un ou l'autre de ces inconvénients, selon leur constitution.

Les oscillateurs élémentaires composant le réseau pourront être construits d'après le brevet français n° 2 876 180 de la demanderesse ; c'est dans la façon particulière d'associer de tels oscillateurs qu'il faut chercher l'originalité de l'invention. Le brevet antérieur ne mentionne pas de réseau d'oscillateurs.

On ressent le besoin de créer un réseau d'oscillateurs mécaniques ou électromécaniques couplés entre eux et dont la structure est simple et formée d'un nombre réduit d'éléments. Il en résulterait une fabrication facile, notamment pour les techniques de dépôt et de gravure usuelles en microtechnologie micromécanique ou nanomécanique), qui donnerait un produit aux dimensions précises. Il serait alors possible de construire en réseau aux oscillateurs de très petites dimensions, donc avec une densité d'intégration élevé sur le substrat, d'y faire passer des fréquences élevées, de l'ordre du gigahertz au moins, sans compromettre la transmission des signaux dans le réseau d'oscillateurs de l'invention, et avec de bonnes caractéristiques de coupure de la transmission autour des modes propres d'oscillation, et des pertes excessives d'énergie. Enfin, il serait possible d'ajuster facilement les paramètres de fabrication et donc les caractéristiques du réseau, comme les fréquence propres et les caractéristiques de couplage, ou d'ajouter un moyen de réglage particulier, intégré au réseau et offrant les mêmes possibilités d'ajustement une fois que le dispositif aura été fabriqué. Les oscillateurs, et les moyens de couplage devraient être formés d'un nombre réduit d'éléments pour donner ces avantages.

Une réalisation générale de l'invention concerne un oscillateur mécanique **caractérisé en ce qu**'il comprend un réseau de cellules jointes entre elles, chacune des cellules étant un oscillateur élémentaire comprenant une poutre déformable s'étendant sur une ligne fermée, et des poutre déformables de liaison s'étendant sur des lignes et jointes à une pluralité des poutres s'étendant sur une ligne fermée.

Au sens de l'invention, les poutres déformables changent effectivement de forme pendant la vibration, en absorbant et restituant alternativement de l'énergie cinétique et de l'énergie de déformation ; et les poutres de liaison, souvent rectilignes, s'étendent sur une grande longueur dans le réseau, le long d'une pluralité des cellules alignées parallèlement auxdites poutres. Enfin, les poutres de liaison comprennent des points d'ancrage au substrat fixe, régulièrement espacées d'un pas égal à un multiple du pas des cellules. Cette disposition permet d'instaurer des modes de vibration à fréquence très élevée aux poutres de liaison, qui sont transmis le long de celle-ci à d'autres régions du réseau, grâce à la faculté d'imposer des déformations complexes entre les paires de points d'ancrage par un nombre suffisant d'oscillateurs, qui correspondent à des modes propres à ces fréquences très élevées.

Souvent, l'oscillateur élémentaire comprend aussi des masses rigides oscillantes jointes de façon rigide à la poutre s'étendant sur une ligne fermée.

Avantageusement, les oscillateurs sont des résonateurs.

Dans de nombreuses réalisations, le réseau de cellules est bidimensionnel ; les poutres de liaison peuvent alors être jointes à une pluralité de poutres s'étendant sur une ligne fermée réparties par paires de deux côtés opposés des poutres de liaison, ce qui permet d'établir un couplage non seulement dans la direction des poutres de liaison mais dans la direction perpendiculaire ;

L'information pourra alors être transmise dans cette direction perpendiculaire à la direction des poutres de liaison aussi bien que dans la direction des poutres de liaison.

Les cellules peuvent aussi être délimitées par deux poutres de liaison en sus des deux poutres de liaison déjà mentionnées, ces autres poutres étant jointes aux précédentes en formant des quadrilatères : des couplages sensiblement uniformes peuvent alors être établis entre les deux directions principales du réseau.

Un élément important de l'invention concerne les ancrages du réseau à un substrat fixe pour régler les caractéristiques de couplage. Selon l'invention, les points d'ancrage au substrat sont essentiellement présents sur les poutres de liaison. Contrairement à la conception nécessaire avec des oscillateurs isolés qu'on exposait dans le brevet français susmentionné, les points d'ancrage du présent réseau peuvent être disposés selon un mode périodique admettant un pas égal à un multiple d'une longueur d'une cellule, ce qui signifie que la plupart des points des cellules ne sont pas ancrés. Le couplage résultant, plus faible, consomme moins d'énergie et autorise une meilleure transmission de l'information dans le réseau.

Le réseau peut être compliqué par des dispositifs de couplage, comprenant des poutres déformables s'étendant sur une ligne fermée dépourvu de masses rigides oscillantes, entre des paires de cellules voisines. Une telle disposition a l'avantage de permettre une modification facile des caractéristiques d'oscillation du réseau.

Un autre moyen important de régler le couplage dans le réseau consiste à le pourvoir d'électrodes de création de champs électriques devant les poutres s'étendant sur une ligne fermée, les poutres de liaison, ou toutes, afin de modifier la raideur des poutres et donc la fréquence des vibrations qu'elles transmettent.

Ces aspects de l'invention ainsi que d'autres seront maintenant décrits au moyen des figures suivantes :
- la figure 1 illustre une réalisation d'oscillateur élémentaire ;
- les figures 2, 3, 4 et 5 illustrent quatre réalisations de réseaux de tels oscillateurs;
- la figure 6, 7 et 8 illustrent un mode de propagation des oscillations dans une cellule, puis deux, puis à 3 cellules ou plus (réseau) d'après le cas général ;
- la figure 9, 10 et 11 illustrent trois mode d'oscillation dans des réseaux bidimensionnels ;
- les figures 12 et 13 illustrent deux réalisations de coupleurs sans masse ;
- les figures 14, 15, 16 et 17 illustrent quatre réalisations de réseaux pourvus de tels coupleurs;
- et les figures 18, 19 et 20 illustrent trois dispositions d'électrodes d'ajustement de raideur des poutres.

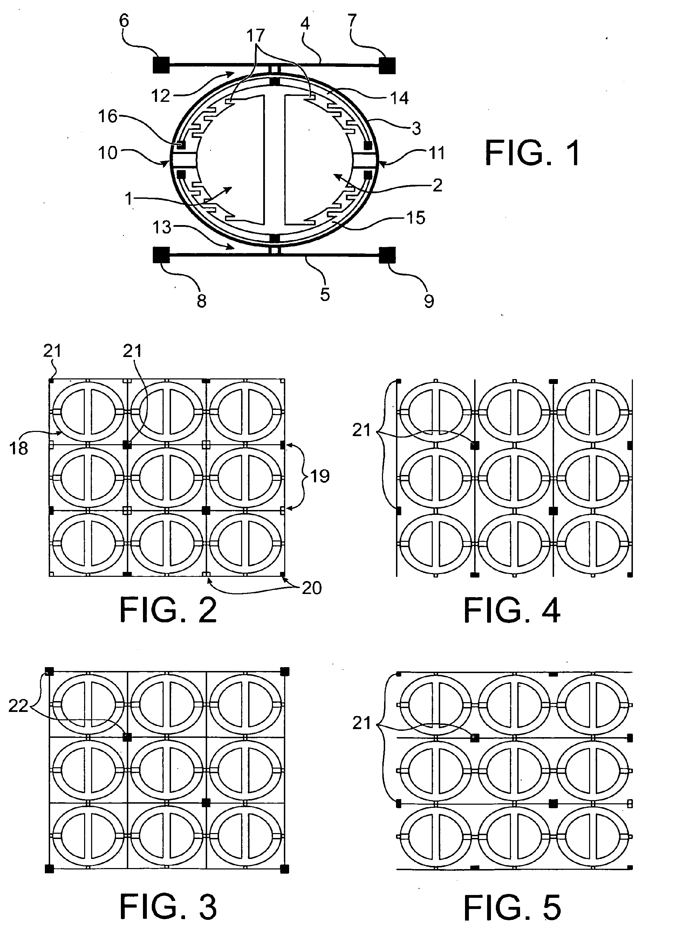

La figure 1 représente un oscillateur élémentaire. Il comprend deux masses 1 et 2 rigides entourées par une poutre s'étendant sur une ligne fermée 3 déformable que soutiennent deux poutres d'ancrage parallèles 4 et 5 déformables et avantageusement rectilignes (pour faciliter l'assemblage du réseau) menant à quatre points d'ancrage 6, 7, 8 et 9 à un substrat sous-jacent. La poutre déformable s'étendant sur une ligne fermée 3 est reliée aux masses 1 et 2 et aux poutres d'ancrage 4 et 5 par des poutres de raccordement 10, 11, 12 et 13. Ces poutres de raccordement, qui sont ici doublées en paires de poutres parallèles, sont très rigides et courtes par rapport aux précédentes, de sorte qu'on peut considérer qu'elles transmettent parfaitement les mouvements ou les déformations des éléments qu'elles relient. Enfin, l'oscillateur comprend des moyens de mise en oscillation des masses 1 et 2 constitués par des peignes 14 et 15 fixes logés entre la poutre s'étendant sur une ligne fermée 3, les masses 1 et 2 et les poutres de raccordement 10 et 11. Ils sont détachés des autres éléments de l'oscillateur mais fixés au substrat par des points d'ancrage communément référencés par 16 et qui peuvent être au nombre de trois pour chacun des peignes 14 et 15. Leurs dents sont imbriquées, ou "interdigitées" selon le vocabulaire fréquemment employé dans la technique, dans des dents communément référencées par 17 de peignes mobiles établis sur les masses 1 et 2. L'oscillateur est en silicium revêtu de couches conductrices au moins sur les peignes fixes qui servent à générer des champs électriques.

Dans le mode de réalisation préféré, la poutre s'étendant sur une ligne fermée 3 est elliptique, les poutres d'ancrage 4 et 5 sont parallèles au grand axe de l'ellipse de la poutre 3, les points d'ancrage 6, 7, 8 et 9 sont aux coins d'un rectangle et les masses 1 et 2 sont en forme de demi-lune, leurs dents 17 étant placés sur les faces bombées, éloignées l'une de l'autre, et dirigées dans la direction du grand axe de ladite ellipse ; les dents des peignes 14 et 15 sont dirigées de même. Cette disposition permet d'instaurer des forces électriques en commandant le potentiel électrique des peignes fixes 14 et 15 (pour des dispositifs qui ne sont pas représentés mais sont bien connus dans l'art) pour instaurer les mouvements des masses 1 et 2 dans la direction du grand axe de l'ellipse qui déforment la poutre s'étendant sur une ligne fermée 3 et les poutres d'ancrage 4 et 5. Le contour fermé de la poutre 3, et notamment sa forme elliptique, ainsi que l'orientation des poutres d'ancrage 4 et 5 favorisent l'apparition d'une opposition de phase du mouvement des masses 1 et 2, qui s'éloignent et s'approchent donc sans cesse l'une de l'autre quand elle sont excitées, alors que les autres modes de vibration possibles apparaissent beaucoup moins facilement, puisque le réseau de poutres serait par exemple beaucoup plus rigide pour un mouvement des masses 1 et 2 eu phase.

Dans la figure 1, la configuration proposée (et originale) des peignes fixes 14 et 15 contraint le mouvement voulu en opposition de phase avec un unique signal électrique : on n'a pas besoin d'amener le signal en opposition de phase par deux peignes distincts le dispositif comprend un plot de connexion électrique, un fil électrique et un groupe de peignes fixes au lieu de deux fils et deux groupes de peignes comme dans l'art antérieur.

On retrouvera cet oscillateur élémentaire dans les réseaux qui vont maintenant être décrits, en donnant une représentation simplifiée où les peignes et leurs dents ne seront pas illustrés. Toutefois, les peignes peuvent être présents ou non sur les oscillateurs selon que ceux-ci sont moteurs ou simplement transmetteurs des oscillateurs. Les oscillateurs peuvent éventuellement être différents les uns des autres, notamment en ce qui concerne leurs masses et leurs rigidités. Les masses oscillantes 1 et 2 peuvent elles-mêmes être omises, si on cherche notamment des réseaux capables de propager à des fréquences très élevées.

Certaines formes de l'invention auront les allures représentées aux figures 2, 3, 4 et 5, où les oscillateurs élémentaires portent la référence 18 et sont regroupés en réseaux bidimensionnels dont ils occupent une cellule chacun. Un aspect important à considérer est que les poutres d'ancrage 4 et 5 de l'oscillateur élémentaire de la figure 1 sont désormais communes à plusieurs oscillateurs élémentaires 18, c'est-à-dire qu'elles se prolongent de façon continue d'un oscillateur élémentaire 18 à ses voisins sur des distances pouvant être importantes. On parlera désormais de poutres de liaison, de référence 19 pour des poutres s'étendant dans une direction (ici, le long des grands axes des ellipses comme les poutres d'ancrage 4 et 5 de l'oscillateur élémentaire de la figure 1), et de référence 20 pour des poutres similaires aux précédentes, et notamment déformables, mais qui s'étendent parallèlement aux petits axes des ellipses. Ces secondes poutres de liaison 20, qui n'ont pas leur équivalent dans le dispositif de la figure 1, sont généralement jointes aux poutres de liaison 19 aux endroits de leurs croisements.

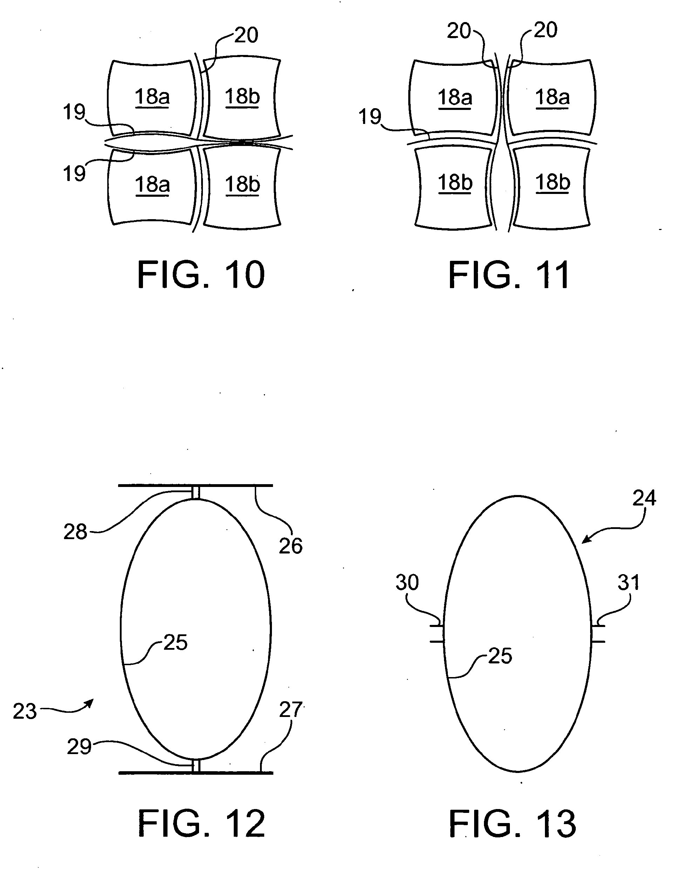

Les poutres de liaison 19 et 20 ont été représentées comme communes aux oscillateurs élémentaires 18 des deux côtés desquels elle s'étendent, c'est-à-dire raccordées à tous ces oscillateurs élémentaires, mais cela n'est pas obligatoire et elles pourraient être remplacées par des dispositions à poutres de liaison 19 et 20 parallèles et contiguës, chacune reliées aux oscillateurs élémentaires 18 d'un côté respectif ainsi qu'on le voit à titre d'exemple aux figures 10, 11 et 16.

Dans le mode de réalisation de la figure 2, les premières et secondes poutres de liaison 19 et 20 s'entrecroisent en formant des contours continus et rectangulaires pour chacune des cellules englobant chacune un des oscillateurs élémentaires 18. Il en va de même pour la figure 3. La figure 4 représente un agencement où seules les secondes poutres de liaison 20 existent, et la figure 5 un agencement où seules les premières poutres de liaison 19 existent.

Un autre aspect à considérer de ces réseaux est celui des points d'ancrage. La jonction d'un réseau d'oscillateurs élémentaires 18 par les poutres de liaison 19 et 20 permet d'utiliser un nombre de points d'ancrage moins important qu'à chaque coin d'un des oscillateurs élémentaires 18 : dans la réalisation de la figure 2, les points d'ancrage 21 sont présents à deux coins opposés de chacun des oscillateurs élémentaires 18, c'est-à-dire qu'ils sont disposés en quinconce d'une poutre de liaison 19 ou 20 à la suivante, étant présents à un pas de deux cellules sur chacune des poutres de liaison 19 et 20 et avec un décalage d'une poutre de liaison 19 ou 20 à la suivante ; dans la réalisation de la figure 3, les points d'ancrage 22 sont présents à un pas de trois cellules sur chacune des poutres de liaison 19 et 20, encore avec un décalage les mettant en quinconce ; d'autres dispositions des point d'ancrage sont possibles, les périodiques étant préférées. Les croisements avec raccordements entre elle des poutres de liaison 19 et 20 permettent théoriquement de recourir à un nombre de points d'ancrage très petit pour faire tenir le réseau sur le substrat, sauf à accepter qu'il soit très peu rigide. Dans la réalisation de la figure 4 et celle de la figure 5, on a choisi des motifs de points d'ancrage 21 semblables à celui de la figure 2 et qui portent donc la référence 21.

Les oscillations en opposition de phase étant favorisées pour chacun des oscillateurs élémentaires 18, et la poutre s'étendant sur une ligne fermée 3 elliptique se déforment dans les deux direction orthogonales du plan, la déformation de l'un d'eux peut être propagée à ses voisins et dans tout le réseau par les poutres de liaison 19 et 20.

Le fonctionnement des réseaux dépendra d'un certain nombre de facteurs, outre des caractéristiques des oscillateurs élémentaires 18 :
- la présence ou l'absence de certaines des poutres de liaison entre les oscillateurs élémentaires 18 voisins ;
- le dédoublement éventuel des poutres de liaison en poutres parallèles et contiguës dont l'une suit les déplacements de la rangée des oscillateurs élémentaires 18 d'un côté, et l'autre celle des oscillateurs élémentaires 18 de l'autre côté : de telles poutres dédoublées et contiguës peuvent se déformer indépendamment ; quand cette disposition est adoptée, les oscillateurs opposés en haut et en bas subissent des déplacements indépendants, alors que ces déplacements sont forcément opposés pour des oscillateurs élémentaires 18 joints à une poutre de liaison 19 ou 20 mitoyenne et commune ;
- le nombre et la répartition de points d'ancrage. Leur écartement généralement périodique définit des motifs dans le réseau, dont les caractéristiques sont identiques. Dans les réalisations des figures 2, 4 et 5, les motifs auront une étendue de 2 x 2 cellules ; dans celui de la figure 3, une étendue 3 x 3 cellules ;
- l'existence de croisements avec raccordements des poutres de liaison 19 ou 20 aux limites des cellules qui ne sont pas pourvues de point d'ancrage ;
- la raideur des poutres de liaison ;
- l'isotropie ou l'anisotropie du réseau pour les deux directions principales définies le long des poutres de liaison 19 et 20 ;
- la constance des propriétés des oscillateurs et des poutres de liaison sur la surface du réseau.

D'une façon générale, il est possible de modifier la raideur des poutres déformable et la valeur des masses oscillantes, ainsi que les conditions aux limites des poutres ; oscillantes (elles sont presque immobiles aux points d'ancrage, et liées entre elles aux intersections avec raccordement aux poutres de liaisons perpendiculaires de manière que leurs déplacements angulaires sont identiques), et ainsi d'agir sur la fréquence de résonance globale ou locale du réseau, selon que les ajustements portent sur l'ensemble du réseau ou une portion de celui-ci, et donc sur la vitesse à laquelle une information parcourra le réseau. Quelques fonctionnements seront maintenant exprimés à l'aide des figures suivantes.

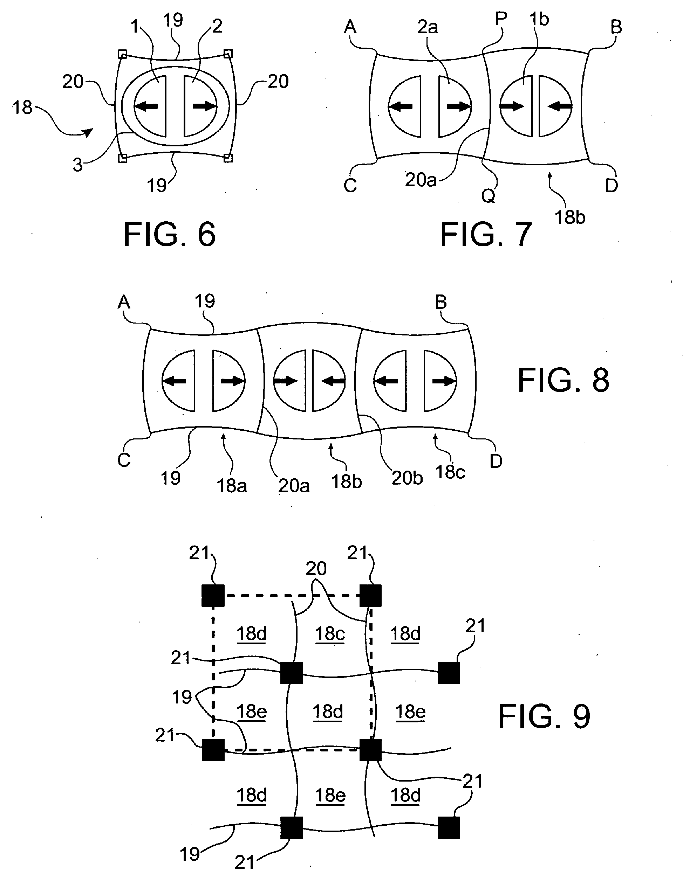

La figure 6 représente la façon dont un oscillateur élémentaire 18 particulier se déforme : les masses 1 et 2 se déplacent en opposition de phase, la poutre s'étendant sur une ligne fermée 3 se déforme avec une modification du rapport de longueur des axes de l'ellipse et les poutres de liaison 19 se déforment aussi en opposition de phase, par exemple en rendant la cellule concave à leurs endroits ; les poutres de liaison 20, quand elles existent, connaissent aussi des déformations opposées entre elles et qui sont aussi opposées à celles des poutres de liaison 19, de sorte que la cellule devient convexe à leurs endroits. L'allure des déformations et la fréquence de résonance dépendent, entre autres, des conditions aux limites, et notamment de la présence et du nombre de points d'ancrage aux coins de l'oscillateur élémentaire 18, ou de croisements avec raccordement des poutres de liaison.

La figure 7 illustre une paire d'oscillateurs 18 voisins reliés entre eux par une poutre de liaison 20a commune, c'est-à-dire qui est reliée à une des masses de chacun des oscillateurs 18a et 18b. S'il n'y a pas de point d'ancrage aux croisements entre les poutres de liaison 19 et les poutres de liaison commune 20a, aux points P et Q, les poutres de liaison 19 peuvent se déformer sur une étendue plus ample, d'après un mode complexe comprenant ici deux ventres de vibration le long de la paire d'oscillateurs élémentaires 18 considérée, entre les points de limite A et B du quadrilatère A B C D qu'elle forme. La fréquence du mode et sa forme dépendront encore de paramètres multiples de raideur, dimensions, masses et conditions aux limites ainsi qu'on l'a déjà signalé.

Cela peut être généralisé à un plus grand nombre d'oscillateurs, par exemple aux trois oscillateurs élémentaires 18a, 18b et 18c de la figure 8 : deux poutres de liaison communes 20a et 20b les relient ; les poutres de liaison 19 se déforment d'après un mode s'étendant sur l'étendue des trois cellules considérées et qui dépend encore des mêmes paramètres, dont les conditions aux limites aux coins A, B, C et D de ce motif de cellules.

Dans la pratique, dans les techniques de micro-usinage du silicium, on cherchera des fréquences de résonance de l'ordre du kilohertz ou du mégahertz avec des motifs d'au moins deux ou trois cellules, voire une dizaine de cellules, de côté. Dans les techniques de nano-usinage, il sera possible d'exploiter des motifs d'ordre plus élevé et des fréquences de résonance supérieures au gigahertz, et qui pourront être encore augmentées en réduisant les masses oscillantes 1 et 2 ou même en les supprimant complètement pour certaines au moins des cellules du réseau. Plus l'invention sera réalisée en petite dimension et avec beaucoup de cellules, plus le réseau pourra être grand en nombre de cellules et donc en variation de durée de propagation.

On revient au réseau de la figure 2 en soulignant qu'il représente un des modes de réalisation préférés d'abord à cause de la régularité de sa structure, qui lui donne une isotropie assez grande, et ensuite en raison de ce que les oscillateurs élémentaires se répartissent en deux groupes qu'illustre la figure 9. En suivant les lignes comme les colonnes du réseau, on trouve que les oscillateurs élémentaires 18 prennent en alternance deux phases de déformation opposées pour l'étendue du motif, notées 18d et 18e respectivement, grâce à la présence des points d'ancrage 21 en quinconce et au caractère commun des poutres de liaison 19 et 20. La transmission simultanée d'une phase d'un signal comme de son opposée est donc parfaitement déterminée et imposée le long du réseau. Cette particularité est recherchée dans de nombreuses applications en électronique. Elle est aussi intéressante d'un point de vue mécanique puisque le centre de gravité d'un réseau reste immobile, ce qui le rend plus stable, et la dissipation d'énergie est minimisée en régime stationnaire.

Les figures 10 et 11 illustrent d'autres possibilités, obtenues quand seules les poutres de liaison 20 ou les poutres de liaison 19 sont communes et que les autres sont dédoublées : l'alternance de phases opposées entre les cellules voisines s'effectue seulement le long des lignes dans l'agencement de la figure 10, le long des colonnes dans celui de la figure Il ; mais d'une ligne à l'autre ou d'une colonne à l'autre, la répartition des phases est quelconque entre des oscillateurs élémentaires 18 voisins en l'absence de liaison, et il est possible qu'ils soient à la même phase, ce qu'on a représenté sur ces figures. Les lignes ou colonnes sont alors des transmetteurs indépendants.

D'autres aspects de l'invention vont maintenant être décrits. Tout d'abord, des coupleurs, représentés aux figures 12 et 13 pour leurs modes de réalisation principaux, peuvent être ajoutés à certains endroits du réseau entre certaines des cellules déjà décrites. Ces deux formes de réalisation ont en commun une poutre s'étendant sur une ligne fermée 25, de préférence elliptique comme la poutre 3 ; elle est munie de poutres de liaison 26 et 27 aux portons voisines du réseau parallèles à la figure 12 et qui sont jointes aux extrémités de la poutre s'étendant sur une ligne fermée 25 d'après le grand axe de l'ellipse par des poutres de raccordement 28 et 29, ou d'une paire de poutres de raccordement 30 et 31 aux extrémités du petit axe de l'ellipse et dirigées dans la direction de cet axe à la figure 13.

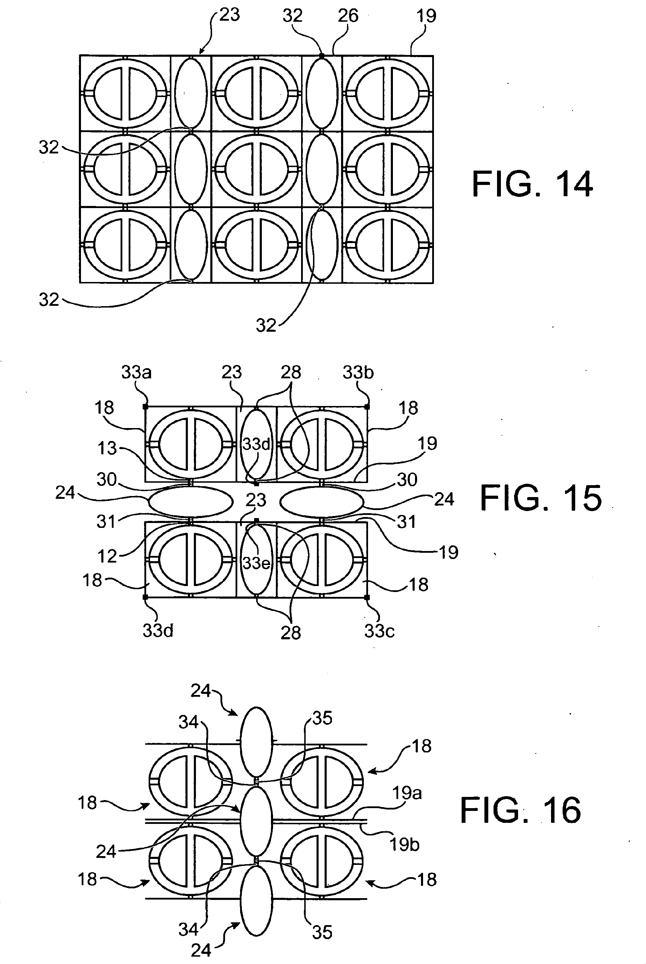

Ces coupleurs 23 et 24 peuvent être implantés sur le réseau de diverses façon dont les figures suivantes illustrent des exemples. A la figure 14, des coupleurs 23 alignés en colonnes séparent des oscillateurs élémentaires 18 dans chacune des lignes, leurs poutres de jonction 26 étant incorporées aux poutres de jonction 19. Des points d'ancrage 32 supplémentaires peuvent être ajoutés pour augmenter la raideur du réseau, comme aux intersections des poutres de raccordement 28 et 29 avec les poutres de liaison 19, encore selon un motif en quinconce, à un croisement sur deux le long de chacune des colonnes et avec un décalage de colonnes d'une poutre de liaison 19 à la suivante. Dans le mode de réalisation représenté, les poutres de liaison 19, communes à deux rangées d'oscillateurs élémentaires 18, sont en prolongement des poutres de liaison 26 et 27 des coupleurs 23 et confondues avec elles.

Une disposition analogue est retenue pour le réseau de la figure 15, mais les lignes sont cette fois séparées par des coupleurs 24 du second genre, placés de façon renversée par rapport aux coupleurs 23 de la figure 14 (qu'on retrouve ici), c'est-à-dire avec des axes d'ellipses perpendiculaires. Une telle disposition permet de raccorder les poutres de raccordement 30 et 31 aux poutres de liaison 19 devant les poutres 12 et 13 des oscillateurs élémentaires 18. Ici, les poutres de jonction 20 sont interrompues à l'endroit des coupleurs 24. Les points d'ancrage 33 sont répartis de façon un peu plus complexes, aux coins de chaque motif comprenant quatre oscillateurs élémentaires 18 (33a, 33b, 33c et 33d) et quatre coupleurs 23 et 24 et, près du centre du motif, aux raccordements entre les poutres 28 et 29 des poutres de raccordement des coupleurs 23 et des poutres de liaison 19 (33d et 33e).

Une disposition différente est illustrée à la figure 16. Elle comprend exclusivement des coupleurs 24 du second genre , disposés en colonnes séparant des colonnes d'oscillateurs élémentaires 18 comme à la figure 14, mais les coupleurs 24 sont disposés en quinconce par rapport aux oscillateurs élémentaires 18, c'est-à-dire que leurs petits axes d'ellipse sont alignés avec les poutres de liaison 19, avec lesquelles leurs poutres de raccordement 30 et 31 se confondent. Dans le cas fréquent où ces poutres de raccordement 30 et 31 comprennent deux éléments parallèles, il est indiqué d'employer des poutres de jonction 19a et 19b dédoublées et respectivement associées à la rangée supérieure et la rangée inférieure d'oscillateurs élémentaires 18. Les coupleurs 24 sont ici munis de poutres de raccordement 34 courtes et rigides qui les unissent à leurs extrémités de grand axe d'ellipse. Les points d'ancrage 35 sont placés à ces poutres de raccordement 34.

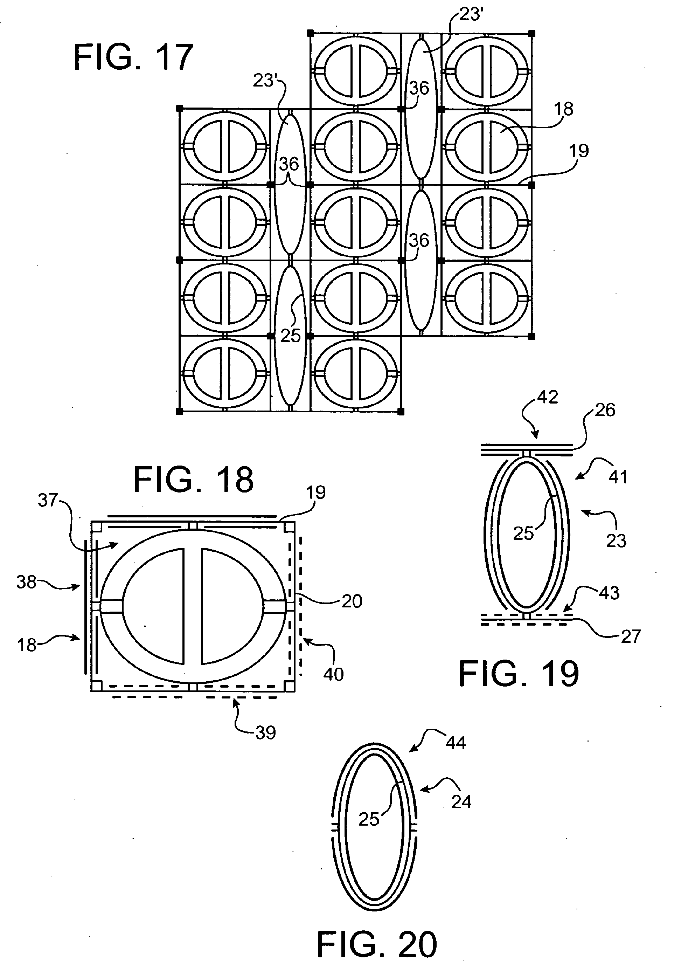

Le réseau de la figure 17 se distingue du précédent par deux caractéristiques : les coupleurs, ici référencés par 23', sont d'une longueur double de celle des oscillateurs 18, c'est-à-dire qu'ils s'étendent entre deux paires de chacun d'eux, et ils s'étendent aussi en quinconce d'une colonne à l'autre, c'est-à-dire que leurs coins et leurs petits axes d'ellipse alternent le long des poutres de liaison 19, qui sont interrompues en arrivant devant les petits axes des ellipses 25. Les points d'ancrage du réseau portent la référence 36 et sont placés à ces interruptions des poutres de liaison 19 ; ici, ils sont aussi placés aux croisements avec les poutres de liaison 20.

D'autres genres de coupleurs pourraient aussi être proposés, mais il n'est pas toujours nécessaire d'en utiliser, dans les réseaux d'oscillateurs de cette invention. La fonction des coupleurs est de régler les propriétés locales et globales du réseau indépendamment des oscillateurs, puisque leurs caractéristiques d'oscillation sont très différentes de celles des oscillateurs, les coupleurs étant presque de dépourvus de masse et leur raideur pouvant être très différente de celle des oscillateurs.

Une dernière caractéristique importante de l'invention qui sera maintenant décrite permet elle aussi d'ajuster dans le temps les couplages entre les éléments du réseau ainsi que la propagation de l'information en lui (couplage dynamique).

La figure 18 montre un oscillateur élémentaire 18 dont les poutres de liaison 19 et 20 sont munies d'électrodes qui les soumettent à un champ électrique. Ces électrodes sont voisines des poutres de liaison 19 et 20 et s'étendent du moins d'un côté des poutre de liaison ou de part et d'autre d'elles. Le champ électrique peut être continu ou alternatif. Les forces électriques agissant sur les poutres de jonction 19 et 20 permettent de modifier leur raideur à l'oscillation et donc la faculté de réagir aux mouvements communiqués aux masses 1 et 2 ou aux oscillateurs élémentaires 18 voisins ; un niveau de couplage faible ou fort d'un oscillateur à un autre peut ainsi être commandé, et le couplage peut même être inhibé complètement en imposant une grande raideur qui rend immobile l'oscillateur élémentaire 18 considéré : la transmission de l'information serait alors interrompue.

Dans le mode de réalisation représenté, on a illustré des électrodes 37 et 38 continues pour une poutre de jonction 19 et une poutre de jonction 20, et des électrodes discontinues 39 et 40 pour l'autre des poutres de jonction 19 et l'autre des poutres de jonction 20. Les électrodes discontinues peuvent être commandées segment par segment et donc offrir une plus grande liberté de réglage. Une répartition quelconque des électrodes continues et discontinues est possible.

La réalisation de la figure 19 concerne le coupleur 23 du premier genre. Des électrodes 41 s'étendent autour de la poutre elliptique 25 (plus précisément autour d'elle pour une des électrodes de la paire et en elle pour l'autre des électrodes de la paire), et des électrodes 42 et 43 devant les poutres de liaison 26 et 27. Ici encore, le choix d'électrodes continues ou discontinues est arbitraire ; on a figuré des électrodes 41 et 42 continues et des électrodes 43 discontinues.

Enfin, la figure 20 représente une paire d'électrodes 44 autour de la poutre elliptique 25 d'un coupleur du second genre 24.

Les électrodes continues sont bien entendu interrompues aux endroits où elles entreraient en collision avec d'autres éléments du réseau, comme les poutres de raccordement.

Des électrodes pourraient aussi être placées près de poutres s'étendant sur une ligne fermée 3 des oscillateurs élémentaires 18 pourvus des masses oscillantes 1 et 2.

## Revendications

1. Oscillateur mécanique comprenant un réseau de cellules jointes entre elles, chacune des cellules étant un oscillateur élémentaire (18) comprenant une poutre s'étendant sur une ligne fermée (3), et des poutres de liaison (19, 20) déformables joignant les poutres s'étendant sur une ligne fermée (3), **caractérisé en ce que** les poutres s'étendant sur une ligne fermée (3) sont déformables les poutres de liaison (19, 20) s'étendent sur des lignes le long d'une pluralité des cellules et l'oscillateur comprend des points d'ancrage (21, 22) des poutres de liaison à un substrat fixe, qui sont disposés le long de chaque poutre de liaison selon un motif périodique admettant un pas égal à un multiple d'une longueur d'une cellule.

2. Oscillateur mécanique selon la revendication 1, **caractérise en ce que** les poutres de liaison sont jointes à une pluralité des poutres s'étendant sur une ligne fermée réparties par paires de deux côtés opposés des poutres de liaison, le réseau de cellules étant bidimensionnel.

3. Oscillateur mécanique selon la revendication 1 ou 2, **caractérisé en ce que** les cellules sont délimitées par deux desdites poutres de liaison et par deux autres poutres de liaison, jointes aux précédentes en formant des quadrilatères.

4. Oscillateur mécanique selon la revendication 1, 2 ou 3, **caractérisé en ce que** le motif est en quinconce, identique pour des poutres de liaison parallèles mais décalé d'une à une autre desdites poutres de liaison parallèles.

5. Oscillateur mécanique selon l'une quelconque des revendications 1 à 4, **caractérisé en ce qu'**il comprend des dispositifs de couplage (23, 24) s'étendant entre des paires des cellules, les dispositifs de couplage comprenant des poutres déformables à contour fermé (25) dépourvues de masses rigides oscillantes, alors que chacun des oscillateurs élémentaires (18) comprend deux masses rigides oscillantes jointes de façon rigide à la poutre s'étendant sur une ligne fermée (3) dudit oscillateur élémentaire.

6. Oscillateur mécanique selon la revendication 5, **caractérisé en ce que** les dispositifs de couplage s'étendent le long d'une pluralité desdites paires de cellules.

7. Oscillateur mécanique selon la revendication 6, **caractérisé en ce que** les dispositifs de couplage s'étendant en quinconce, selon des rangées parallèles où les dispositifs de couplage sont décalés d'une à une autre desdites rangées parallèles.

8. Oscillateur mécanique selon l'une quelconque des revendication 1 à 7, **caractérisé en ce qu'**il comprend des électrodes (41, 44) de création d'un champ électrique de réglage de raideur devant les poutres s'étendant sur une ligne fermée.

9. Oscillateur mécanique selon l'une quelconque des revendications 1. à 8, **caractérisé en ce qu'**il comprend des électrodes (39, 40, 42, 43) de création d'un champ électrique de réglage de raideur devant les poutres de liaison.

## Claims

1. Mechanical oscillator including a network of cells joined together, each of the cells being a basic oscillator (18) including a deformable beam extending along a closed line (3), and deformable linking beams (19, 20) joining the beams extending along a closed line (3), **characterised in that** the beams extending along a closed line (3) are deformable, the linking beams (19, 20) extend over rows along a plurality of cells and the oscillator includes anchoring points (21, 22) for anchoring the linking beams to a stationary substrate, which are arranged along each linking beam according to a periodic pattern allowing a step equal to a multiple of the length of a cell.

2. Mechanical oscillator according to claim 1, **characterised in that** the linking beams are joined to a plurality of beams extending along a closed line distributed by pairs on two opposite sides of the linking beams, wherein the network of cells is two-dimensional.

3. Mechanical oscillator according to claim 1 or 2, **characterised in that** the cells are delimited by two of said linking beams and by two other linking beams, joined to the previous ones to form quadrilaterals.

4. Mechanical oscillator according to claim 1, 2 or 3, **characterised in that** the pattern is staggered, identical for parallel linking beams but offset from one to another of said parallel linking beams.

5. Mechanical oscillator according to any one of claims 1 to 4, **characterised in that** it includes coupling devices (23, 24) extending between pairs of cells, wherein the coupling devices include rigid massless oscillating deformable closed-contour beams (25), while each of the basic oscillators (18) includes two oscillating masses joined rigidly to the beam extending along a closed line (3) of said basic oscillator.

6. Mechanical oscillator according to claim 5, **characterised in that** the coupling devices extend along a plurality of said cell pairs.

7. Mechanical oscillator according to claim 6, **characterised in that** the coupling devices extend in a staggered fashion, in parallel rows in which the coupling devices are offset from one to another of said parallel rows.

8. Mechanical oscillator according to any one of claims 1 to 7, **characterised in that** it includes electrodes (41, 44) for creating an electrical field for adjusting stiffness in front of the beams extending along a closed line.

9. Mechanical oscillator according to any one of claims 1 to 8, **characterised in that** it includes electrodes (39, 40, 42, 43) for creating an electrical field for adjusting stiffness in front of the linking beams.

## Patentansprüche

1. Mechanischer Oszillator, ein Netzwerk miteinander verbundener Zellen umfassend, wobei jede der Zellen ein elementarer Oszillator (18) mit einem sich über eine geschlossene Zeile erstreckenden Träger (3) und die sich über eine geschlossene Zeile erstreckenden Träger (3) verbindenden verformbaren Verbindungsträgern (19, 20) ist,
**dadurch gekennzeichnet, dass** die sich über eine geschlossene Zeile erstreckenden Träger (3) verformbar sind, die Verbindungsträger (19, 20) sich über Zeilen längs einer Vielzahl Zellen erstrecken und der Oszillator Verankerungspunkte (21, 22) der Verbindungsträger auf einem festen Substrat umfasst, die längs jedes Verbindungsträgers gemäß eines periodischen Musters angeordnet sind, das eine Teilung gleich einem Vielfachen einer Länge einer Zelle ermöglicht.

2. Mechanischer Oszillator nach Anspruch 1, **dadurch gekennzeichnet, dass** die Verbindungsträger verbunden sind mit einer Vielzahl sich paarweise auf zwei entgegengesetzten Seiten der Verbindungsträger über eine geschlossene Zeile erstreckender Träger, wobei das Zellennetzwerk zweidimensional ist.

3. Mechanischer Oszillator nach Anspruch 1 oder 2, **dadurch gekennzeichnet, dass** die Zellen begrenzt sind durch zwei der genannten Verbindungsträger und durch zwei andere, mit den vorhergehenden verbundene Verbindungsträger, wobei sie Vierecke bilden.

4. Mechanischer Oszillator nach Anspruch 1, 2 oder 3, **dadurch gekennzeichnet, dass** das Muster von gegeneinander versetzter Anordnung ist, identisch für parallele Verbindungsträger aber vom einem zum andern der genannten parallelen Verbindungsträger versetzt.

5. Mechanischer Oszillator nach einem der Ansprüche 1 bis 4, **dadurch gekennzeichnet, dass** er Kopplungseinrichtungen (23, 24) umfasst, die sich zwischen Zellenpaaren erstrecken, wobei die Kopplungseinrichtungen verformbare Träger mit geschlossener Kontur (25) ohne oszillierende steife Massen umfassen, während jeder der elementaren Oszillatoren (18) zwei mit dem sich über eine Zeile erstreckenden Träger (3) steif verbundene steife oszillierende Massen umfasst.

6. Mechanischer Oszillator nach Anspruch 5, **dadurch gekennzeichnet, dass** die Kopplungseinrichtungen sich längs einer Vielzahl der genannten Zellenpaare erstrecken.

7. Mechanischer Oszillator nach Anspruch 6, **dadurch gekennzeichnet, dass** die Kopplungseinrichtungen sich gegeneinander versetzt erstrecken, gemäß paralleler Reihen, wo die Kopplungseinrichtungen von einer zur andern der genannten parallelen Reihen versetzt sind.

8. Mechanischer Oszillator nach einem der Ansprüche 1 bis 7, **dadurch gekennzeichnet, dass** er Elektroden (41, 44) zur Erzeugung eines elektrischen Steifheitsregelungsfeldes vor den sich über eine geschlossene Zeile erstreckenden Trägern umfasst.

9. Mechanischer Oszillator nach einem der Ansprüche 1 bis 8, **dadurch gekennzeichnet, dass** er Elektroden (39, 40, 42, 43) zur Erzeugung eines elektrischen Steifheitsregelungsfeldes vor den Verbindungsträgern umfasst.
